# EUROPEAN PATENT SPECIFICATION

(11) **EP 2 188 831 B1**
(45) Date of publication and mention of the grant of the patent: **02.12.2015**
(21) Application number: 08795566.2
(22) Date of filing: 25.08.2008
(51) Int. Cl.: H01L 21/302, H01L 21/461, G03F 7/00, G03F 7/027, B82Y 40/00, B82Y 10/00

(54) **REDUCED RESIDUAL FORMATION IN ETCHED MULTI-LAYER STACKS**
REDUZIERTE RESTBILDUNG IN GEÄTZTEN MEHRSCHICHTSTAPELN
FORMATION RÉSIDUELLE RÉDUITE DANS DES EMPILEMENTS MULTICOUCHES GRAVÉS

(30) Priority: 24.08.2007 US 957891 P; 22.08.2008 US 196959
(43) Date of publication of application: 26.05.2010
(73) Proprietor: Canon Nanotechnologies, Inc., Austin, Texas 78758-3650 (US); Molecular Imprints, Inc., Austin, Texas 78758-3650 (US)
(72) Inventor: XU, Frank, Y., Round Rock, TX 78664 (US); LIU, Weijun, Cedar Park, Texas 78613 (US); BROOKS, Cynthia, B., Austin, TX 78751 (US); LABRAKE, Dwayne, L., Cedar Park, Texas 78613 (US); LENTZ, David., J., Leander, TX 78641 (US)
(74) Representative: Ponzellini, Gianmarco
(86) International application number: PCT/US2008/010063
(87) International publication number: WO 2009/029246

(56) References cited:
- EP-A2- 1 270 618
- JP-A- 5 039 321
- US-A1- 2004 137 734
- US-A1- 2004 137 734
- US-A1- 2007 020 555
- US-A1- 2007 034 600
- US-A1- 2007 051 697
- US-A1- 2007 051 697
- Aldrich Corp. General Catalogue: "Reference : Polymer Properties", , pages 52-53, XP002660382, Retrieved from the Internet: URL:http://www.sigmaaldrich.com/etc/medial ib/docs/Aldrich/General_Information/therma l_transitions_of_homopolymers.Par.0001.Fil e.tmp/thermal_transitions_of_homopolymers. pdf [retrieved on 2011-09-30]

## Description

### CROSS-REFERENCE TO RELATED APPLICATIONS

This application claims the benefit under 35 U.S.C. §119(e)(1) of U.S. provisional application 60/957,891, filed August 24, 2007.

### STATEMENT REGARDING FEDERALLY SPONSORED

### RESEARCH OR DEVELOPMENT

The United States government has a paid-up license in this invention and the right in limited circumstance to require the patent owner to license others on reasonable terms as provided by the terms of 70NANB4H3012 awarded by National Institute of Standards (NIST) ATP Award.

### TECHNICAL FIELD

The field of the invention relates generally to nano-fabrication of structures, and more particularly to reduced residual formation in the fabrication of multi-layer stacks.

### BACKGROUND

Nano-fabrication involves the fabrication of very small structures, e.g., having features on the order of nanometers or smaller. One area in which nano-fabrication has had a sizeable impact is in the processing of integrated circuits. As the semiconductor processing industry continues to strive for larger production yields while increasing the circuits per unit area formed on a substrate, nano-fabrication becomes increasingly important. Nano-fabrication provides greater process control while allowing increased reduction of the minimum feature dimension of the structures formed. Other areas of development in which nano-fabrication has been employed include biotechnology, optical technology, mechanical systems and the like.

An exemplary nano-fabrication technique is referred to as imprint lithography. Exemplary imprint lithography processes are described in detail in numerous publications, such as United States Patent No. 6,980,259, entitled, "Method and a Mold to Arrange Features on a Substrate to Replicate Features having Minimal Dimensional Variability;" United States Patent Application Publication No. 2004/0065252 filed as United States Patent Application Serial No. 10/264,926, entitled "Method of Forming a Layer on a Substrate to Facilitate Fabrication of Metrology Standards;" and United States Patent No. 6,936,194, entitled "Functional Patterning Material for Imprint Lithography Processes," all of which are assigned to the assignee of the present invention.

An imprint lithography technique disclosed in each of the aforementioned United States patent application publication and United States patents includes formation of a relief pattern in a polymerizable layer and transferring a pattern corresponding to the relief pattern into an underlying substrate. The substrate may be positioned upon a motion stage to obtain a desired position to facilitate patterning thereof. To that end, a template is employed spaced-apart from the substrate with a formable liquid present between the template and the substrate. The liquid is solidified to form a solidified layer that has a pattern recorded therein that is conforming to a shape of the surface of the template in contact with the liquid. The template is then separated from the solidified layer such that the template and the substrate are spaced-apart. The substrate and the solidified layer are then subjected to processes to transfer, into the substrate, a relief image that corresponds to the pattern in the solidified layer.

In multi-layer imprint lithography processes, a first polymeric layer can be formed on top of a substrate, with one or more intervening layers (e.g., adhesion layers, etc.) between the substrate and the polymeric layer. Subsequently, a second polymeric layer can be formed on the first polymeric layer (e.g., to cover or planarize the first polymeric layer). The second polymeric layer can be formed, for example, by imprinting a low-viscosity polymerizable composition or spun on with a more viscous polymerizable composition. In the case of imprinting planarization, a low-viscosity second polymerizable composition (e.g., viscosity of about 2-20 cP at room temperature) can behave like a solvent. In the case of spin-on planarization, the second polymerizable composition will reflow before crosslinking during a thermal bake step. In both cases, if the first polymeric layer includes areas or pockets (e.g., pores) of unreacted first polymerizable composition, the second polymerizable composition can permeate the areas and intermix with the unreacted first polymerizable composition in the first polymeric layer underneath. In some cases, this penetration or infiltration of the second polymerizable composition into the first polymeric layer can disadvantageously alter the properties of the first polymeric layer For example, in a subsequent processing step, the second polymerizable composition can cause micro-masking during a reactive ion etch (RIE) process.

Micro-masking can be understood as follows. At a temperature below its glass transition temperature (Tg), a polymer behaves like a glassy materials, and molecular mobility is at least somewhat restricted. For imprinting at ambient temperature, for example, about 15°C to about 25 °C, polymer chain mobility of components in a polymerizable liquid with a Tg above room temperature is restricted. This restricted polymer mobility leads to a trapping of unreacted (liquid) polymerizable composition among glassy polymer components during imprinting. The glassy polymer components behave like cages, the immobility of which traps the unreacted polymerizable component in the first polymeric layer.

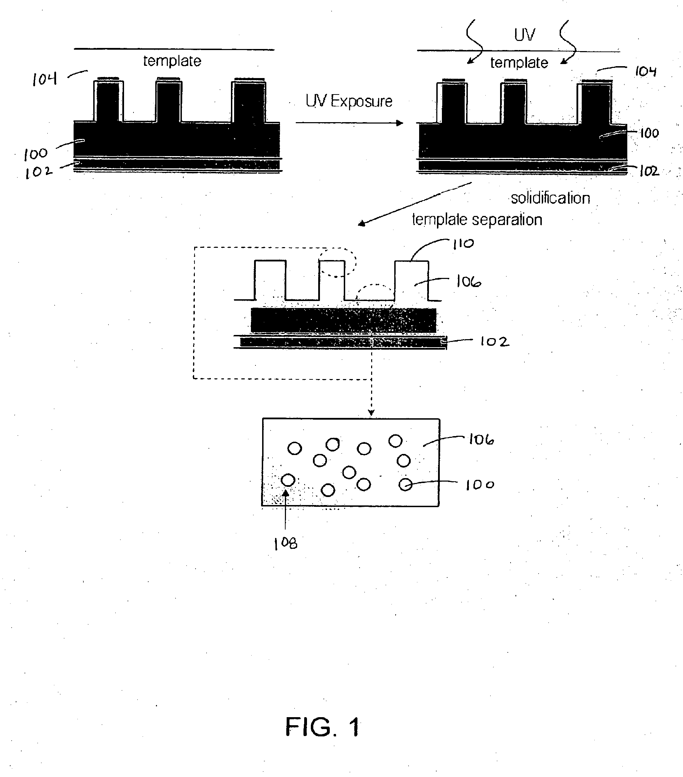

FIG. 1 depicts a cross-sectional view of first polymerizable composition 100 between substrate 102 and template 104. Following polymerization (e.g., UV exposure), the first polymerizable composition 100 solidifies and the template 104 is separated from the polymerized layer 106. If the polymerization is incomplete due, for example, to vitrification during polymerization (i.e., if portions of the polymerizable composition remain in unreacted, liquid form, without bonding to at least one other component in the composition), areas 108 of unreacted first polymerizable composition 100 remain in the polymerized layer 106. In FIG. 1, areas 108 are indicated in and around protrusions 110 in the polymerized layer 106. It is to be understood, however, that areas 108 are located throughout the polymerized layer 106 and are not limited to the indicated regions.

In an example, isobornyl acrylate (IBOA, available as SR 506 from Sartomer Company (Exton, Pennsylvania)) is a mono-functional polymerizable component used in polymerizable compositions in imprint lithography. 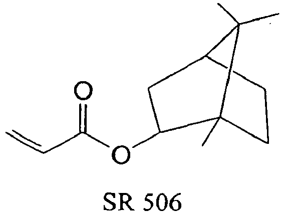 Polyisobornyl acrylate has a Tg of about 88°C. Below about 88°C, polyisobornyl acrylate behaves like a glassy material, with restricted molecular mobility. At imprinting temperatures of about 15°C to about 25°C, polymer chain mobility of polyisobornyl acrylate is restricted. Polymerizable compositions in which a mono-functional polymerizable component with a high Tg such as IBOA predominates undergo vitrification at room temperature, due to the restriction of polymer mobility during bulk polymerization. The remaining unreacted high Tg component is unable to translate/rotate sufficiently to contact a reactive polymeric radical, as needed for chemical reaction to occur. Areas of unreacted polymerizable composition thus remain in the polymerized layer formed by a composition that undergoes vitrification during polymerization. The areas can be thought of as cavities, openings, pores, etc., that subsequently provide a pathway or allow another liquid to more easily infiltrate or permeate the polymerized layer.

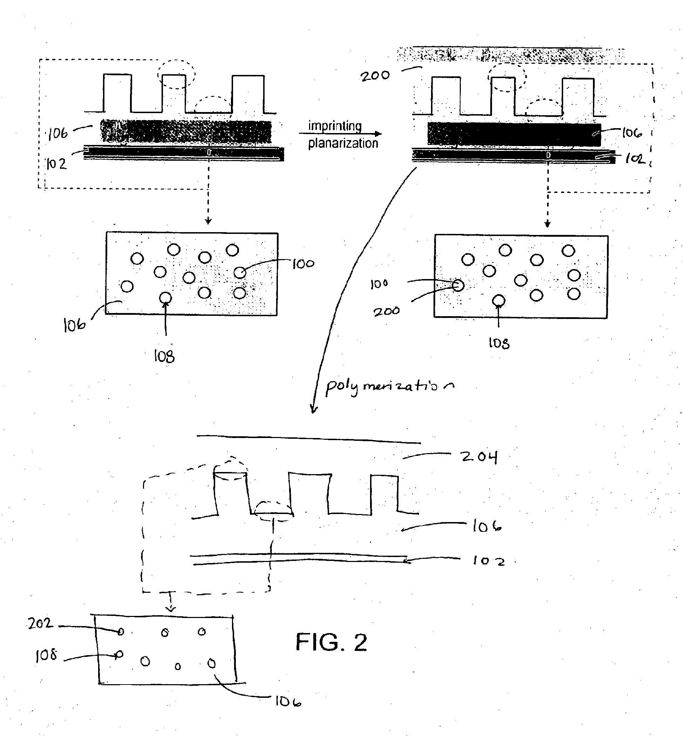

FIG. 2 shows a first polymerized layer 106 with areas 108 of unreacted polymer composition 100. After a second polymerizable composition 200 is applied to the first polymerized layer 106, the second polymerizable composition infiltrates or permeates areas 108 of the first polymerized layer, and intermixes with first polymerizable composition 100 in the area. Polymerization of the second polymerizable composition 200 hardens the second polymerizable composition in areas 108 to form second polymerized material 202 in the areas and to form second polymerized layer 204 on first polymerized layer 106.

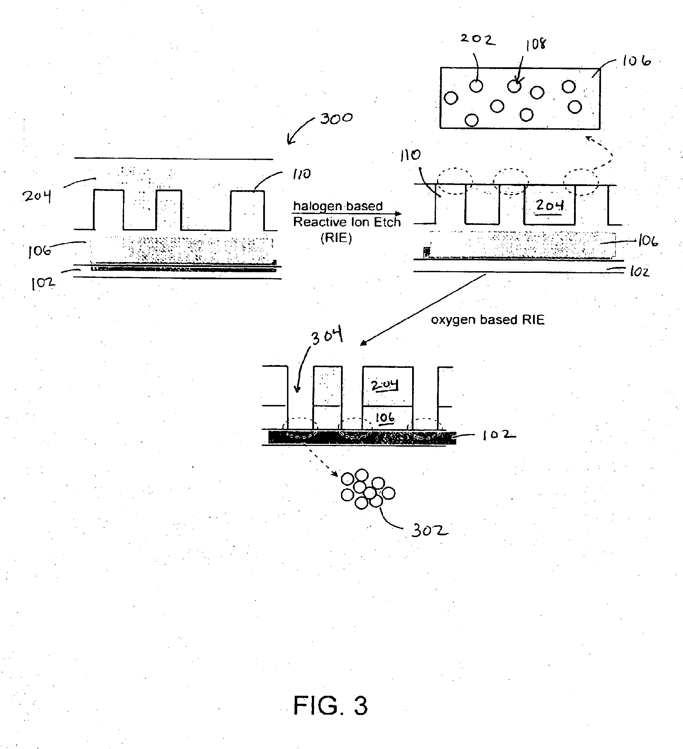

FIG. 3 depicts an etching (reactive ion etching or RIE) process after formation of multi-layer stack 300. In the first step, a portion of the second polymerized layer 204 is removed by halogen-based RIE. This etchback step can involve the use of halogen-containing gas chemistry (e.g., fluorine-containing gas) to remove enough of the second polymerized layer to expose protrusions 110 of the first polymerized layer 106. Second polymerized material 202 in areas 108 of polymerized layer 106 can also be removed by this etching step to form a gaseous product, leaving substantially no residue.

In the next step, oxygen-based gas mixtures can be used in a transfer etch step to remove a portion of the first polymerized material 106 (e.g., to remove protrusions 110). The second polymerized material 202 and second polymerized layer 204 are not removed by the transfer etch step. In some cases, the oxygen will react with components of the second polymerized material 202 in hardened areas 108 to form residue 302. The presence of residue 302 can be undesirable in subsequent applications or processing steps.

When the first polymerizable composition is essentially free of silicon and the second polymerizable composition is silicon-containing, residue 302 can include, for example, oxides of silicon, which are resistant to further oxygen etching. In this case, the second polymerized (silicon-containing) material 202 behaves like a hard mask, and the residue 302 remains in the recesses 304 formed in the transfer etch step.

### SUMMARY

In one aspect, a multi-layer stack used in imprint lithography is formed by applying a first polymerizable composition to a substrate, polymerizing the first polymerizable composition to form a first polymerized layer, applying a second polymerizable composition to the first polymerized layer, and polymerizing the second polymerizable composition to form a second polymerized layer on the first polymerized layer. The first polymerizable composition includes a polymerizable component with a glass transition temperature less than about 25°C, and the first polymerized layer is substantially impermeable to the second polymerizable composition.

In some implementations, the first polymerizable composition includes less than about 1 wt% silicon and the second polymerizable composition is silicon-containing. In other implementations, the first polymerizable composition is substantially free from silicon, and the second polymerizable composition is silicon-containing. The second, silicon-containing polymerizable composition can include, for example, at least about 5 wt% silicon, or at least about 10 wt% silicon.

### BRIEF DESCRIPTION OF THE DRAWINGS

FIG. 1 depicts formation of a first polymerized layer in an imprint lithography process.
FIG. 2 depicts formation of a second polymerized layer in an imprint lithography process.
FIG. 3 depicts reactive ion etching of a multi-layer stack.
FIG. 4 depicts an imprint lithography system.
FIG. 5 depicts an imprint formed in an imprint lithography process.
FIG. 6 shows a cross-sectional view of a multi-layer stack.
FIGS. 7A-C are images of multi-layer stacks (top view) after transfer etching, with a first polymerized layer permeable to a second polymerizable composition.
FIGS. 8A-C are images of multi-layer stacks (top view) after transfer etching, with a first polymerized layer substantially impermeable to a second polymerizable composition.
FIGS. 9A-B are images of multi-layer stacks (cross-sectional view) after transfer etching, showing the presence and absence of residue formed during etching.

### DETAILED DESCRIPTION

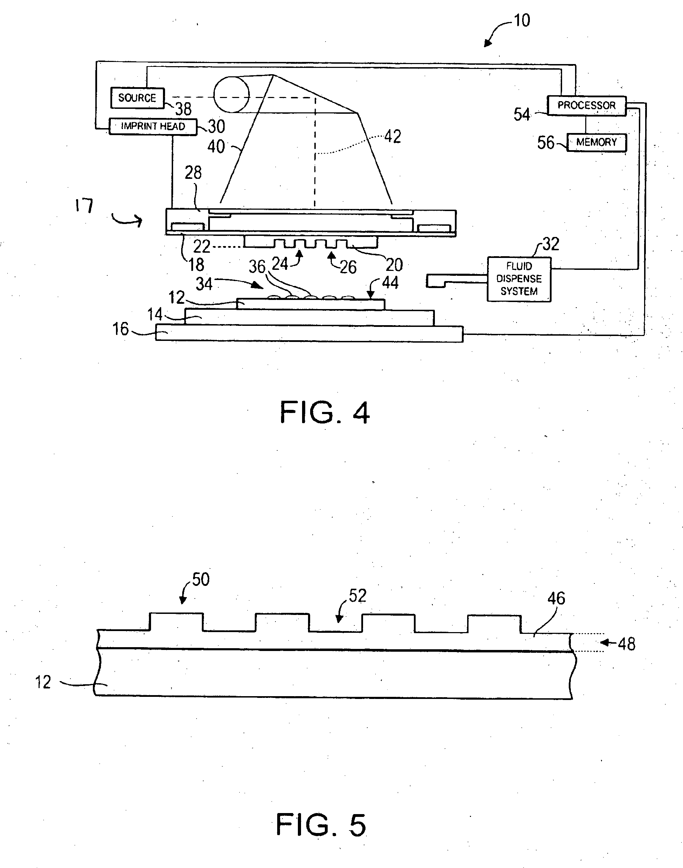

Referring to FIG. 4, a system 10 for forming a relief pattern on a substrate 12 is shown. Substrate 12 may be coupled to a substrate chuck 14. As shown substrate chuck 14 is a vacuum chuck, however, substrate chuck 14 may be any chuck including, but not limited to, vacuum, pin-type, groove-type, or electromagnetic, as described in United States Patent No. 6,873,087, entitled "High-Precision Orientation Alignment and Gap Control Stages for Imprint Lithography Processes". Substrate 12 and substrate chuck 14 may be supported upon a stage 16. Further, stage 16, substrate 12, and substrate chuck 14 may be positioned on a base (not shown). Stage 16 may provide motion about the x and y axes.

Spaced-apart from substrate 12 is a patterning device 17. Patterning device 17 includes a template 18 having a mesa 20 extending therefrom towards substrate 12 with a patterning surface 22 thereon. Further, mesa 20 may be referred to as a mold 20. Mesa 20 may also be referred to as a nanoimprint mold 20. In a further embodiment, template 18 may be substantially absent of mold 20. Template 18 and/or mold 20 may be formed from such materials including, but not limited to, fused-silica, quartz, silicon, organic polymers, siloxane polymers, borosilicate glass, fluorocarbon polymers, metal, and hardened sapphire. As shown, patterning surface 22 includes features defined by a plurality of spaced-apart recesses 24 and protrusions 26. However, in a further embodiment, patterning surface 22 may be substantially smooth and/or planar. Patterning surface 22 may define an original pattern that forms the basis of a pattern to be formed on substrate 12. Template 18 may be coupled to a template chuck 28, template chuck 28 being any chuck including, but not limited to, vacuum, pin-type, groove-type, or electromagnetic, as described in United States Patent No. 6,873,087, entitled "High-Precision Orientation Alignment and Gap Control Stages for Imprint Lithography Processes". Further, template chuck 28 may be coupled to an imprint head 30 to facilitate movement of template 18, and therefore, mold 20.

System 10 further includes a fluid dispense system 32. Fluid dispense system 32 may be in fluid communication with substrate 12 so as to deposit polymerizable material 34 thereon. System 10 may include any number of fluid dispensers, and fluid dispense system 32 may include a plurality of dispensing units therein. Polymerizable material 34 may be positioned upon substrate 12 using any known technique, e.g., drop dispense, spin-coating, dip coating, chemical vapor deposition (CVD), physical vapor deposition (PVD), thin film deposition, thick film deposition, and the like. Polymerizable material 34 can be disposed upon substrate 12 before the desired volume is defined between mold 20 and substrate 12. However, polymerizable material 34 may fill the volume after the desired volume has been obtained.

Referring to FIGS. 4 and 5, system 10 further includes a source 38 of energy 40 coupled to direct energy 40 along a path 42. Imprint head 30 and stage 16 are configured to arrange mold 20 and substrate 12, respectively, to be in superimposition and disposed in path 42. Either imprint head 30, stage 16, or both vary a distance between mold 20 and substrate 12 to define a desired volume therebetween that is filled by polymerizable material 34. After the desired volume is filled with polymerizable material 34, source 38 produces energy 40, e.g., broadband ultraviolet radiation that causes polymerizable material 34 to solidify and/or crosslink, conforming to the shape of a surface 44 of substrate 12 and patterning surface 22, defining a patterned layer 46 on substrate 12. Patterned layer 46 may include a residual layer 48 and a plurality of features shown as protrusions 50 and recessions 52. System 10 may be regulated by a processor 54 that is in data communication with stage 16, imprint head 30, fluid dispense system 32, and source 38, operating on a computer readable program stored in memory 56.

The above-mentioned may be further employed in imprint lithography processes and systems referred to in United States patent 6,932,934 entitled "Formation of Discontinuous Films During an Imprint Lithography Process;" United States Patent No. 7,077,992, entitled "Step and Repeat Imprint Lithography Processes;" and United States Patent No. 7,179,396, entitled "Positive Tone Bi-Layer Imprint Lithography Method"; and United States Patent No. 7,396,475 , entitled Method of Forming Stepped Structures Employing Imprint Lithography".

For multi-layer imprint lithography, the amount of residue formed during etching processes can be reduced or substantially eliminated by reducing vitrification during polymerization of the first layer. Reducing vitrification during polymerization of the first layer can reduce or substantially eliminate areas of unreacted polymerizable composition in the polymerized layer, and thereby reduce subsequent intermixing of materials during fabrication of the multi-layer stack. When, for example, silicon-containing polymerizable materials are inhibited from infiltrating a non-silicon-containing polymerized layer, the formation of silicon oxide etch residues due to micro-masking is reduced or substantially eliminated. A silicon-containing polymerizable material can include, for example, at least about 5 wt% silicon, or at least about 10 wt% silicon. In some cases, it may be desirable for the first polymerizable material to include a small amount of silicon (e.g., less than about 5 wt%, less than about 1 wt%, or less than about 0.1 wt% silicon) in the form of, for example, an additive or release agent. In this case, residue formation may still be reduced relative to a similar silicon-containing polymerizable composition with high Tg components.

Reduction or elimination of vitrification during polymerization can be achieved by selecting a first polymerizable composition that undergoes substantially complete polymerization (e.g., reacts substantially completely) to form a first polymerized layer that is substantially impermeable to a second polymerizable composition. In this case, the second polymerizable composition applied to the first polymerized layer is inhibited from infiltrating (and later solidifying in) openings or open areas in the first polymerized layer.

The first polymerizable composition can include, for example, one or more mono-functional polymerizable components, multi-functional polymerizable components (e.g., crosslinkers), and initiators, along with one or more additives (e.g., release agents), chosen such that the polymerizable components have sufficient mobility during polymerization to avoid the effects of vitrification. Polymerizable components are also advantageously chosen such that the relative reactivity of the components promotes bonding of at least one functional group of each component to another component, without leaving excess unreacted components. The second polymerizable composition can include any polymerizable composition (e.g., overcoat or planarization composition) known in the art.

To reduce or substantially eliminate vitrification during polymerization, a mono-functional polymerizable component is selected such that the Tg of the homopolymer of that component is below the temperature at which imprinting will occur (e.g., below about room temperature or below about 25°C, below about 15°C, below about 10°C, below about 5°C, or below about 0°C). When two or more mono-functional components are present, the mono-functional components are chosen to be predominately low Tg. That is, high Tg (higher than room temperature) polymerizable components may be included in the polymerizable composition if desired, to the extent that the polymerizable compositions does not exhibit substantial vitrification or incomplete polymerization during the fabrication process.

Mono-functional polymerizable components with a polymer Tg below about room temperature can include, for example, (2-ethyl-2-methyl-1,3-dioxolan-4-yl) methyl acrylate, with a Tg of-7°C, shown below, available as MEDOL 10 from Osaka Organic Chemical (Japan). At room temperature, MEDOL 10 homopolymer behaves like a rubbery material, and MEDOL 10 polymer chains have enough mobility to avoid the vitrification effect during polymerization.

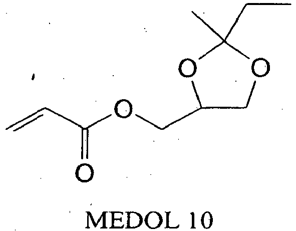

The multi-functional polymerizable component or crosslinker can be selected to promote substantially complete polymerization (e.g., bonding of at least one functional group per molecule) during imprinting and to add mechanical strength to the imprinted layer. A multi-functional polymerizable component (e.g., a crosslinker with more than one acrylate group) is more likely to polymerize during the imprinting process than a mono-functional polymerizable component. An exemplary crosslinker is neopentyl glycol diacrylate, shown below, available as SR247 from Sartomer Company.

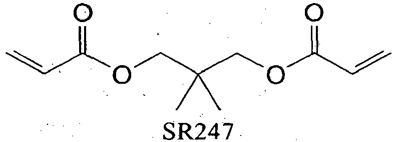

Another exemplary crosslinker is 1,6-hexanediol diacrylate (HDODA), shown below, available from Cytec Industries, Inc. (West Paterson, New Jersey).

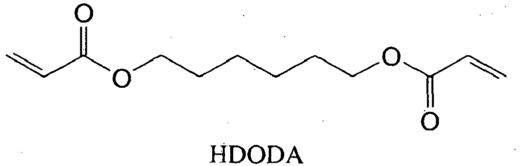

The polymerizable components will react substantially completely during the imprint lithography process when a mono-functional polymerizable component in the composition has a desired reactivity with respect to that of a multi-functional component in the composition. If the mono-functional polymerizable component reacts too slowly with respect to the multi-functional polymerizable component, an amount of the mono-functional polymerizable component may still be present when the multi-functional polymerizable component has been substantially consumed. This may lead to the trapping of the un-reacted mono-functional polymerizable component. For example, the dioxolan ring in MEDOL 10 provides enough polarity to allow the acrylic group to react relatively quickly in the presence of a crosslinker such as SR247. In comparison, n-decyl acrylate, which has a Tg below room temperature but is much more non-polar than MEDOL 10, reacts slowly compared to a crosslinker such as SR247. When the crosslinker is substantially consumed and unreacted mono-functional polymerizable component remains, the unreacted monomer is trapped, leaving areas of unreacted polymerizable composition in the solidified layer.

The polymerizable composition can include one or more photoinitiators, chosen to absorb electromagnetic radiation in one or more wavelength ranges. One example of a photoinitiator is 2-methyl-1[4-(methylthio)phenyl]-2-morpholinopropan-1-one, shown below, available as IRGACURE 907 from Ciba (Switzerland).

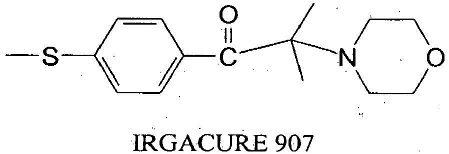

Another example of a photoinitiator is 2,4,6-trimethylbenzoyldiphenylphosphine oxide (TPO), shown below, available from BASF (Germany).

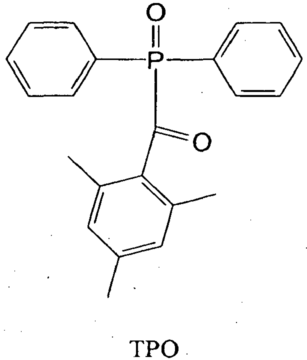

DAROCUR 4265, a photoinitiator mixture available from Ciba, is a 1:1 mixture of TPO and 2-hydroxy-2-methyl-1-phenyl-propan-1-one, shown below.

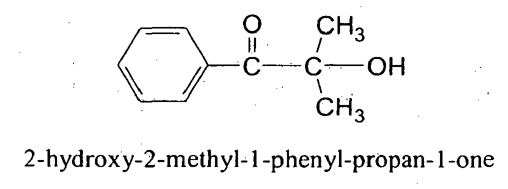

The following example is provided to more fully illustrate some of the embodiments of the present invention. It should be appreciated by those of skill in the art that the techniques disclosed in the examples which follow represent techniques discovered by the inventors to function well in the practice of the invention, and thus can be considered to constitute exemplary modes for its practice. However, those of skill in the art should, in light of the present disclosure, appreciate that many changes can be made in the specific embodiments that are disclosed and still obtain a like or similar result without departing from the spirit and scope of the invention.

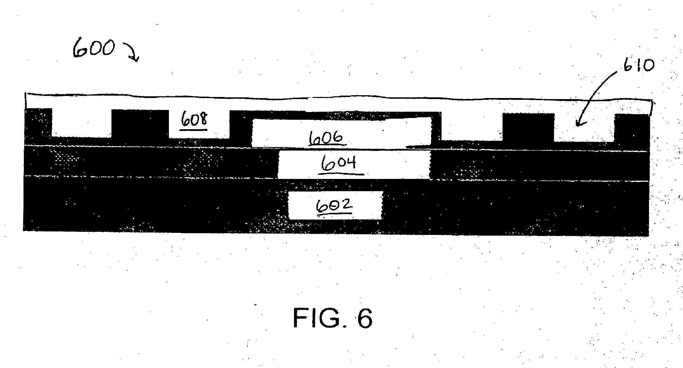

**COMPARATIVE EXAMPLE.** FIG. 6 depicts a multi-layer stack 600 with substrate 602, adhesive layer 604, first polymerized (non-silicon-containing) layer 606, and second polymerized (silicon-containing) layer 608. Multi-layer stacks were prepared with polymerizable composition 1 (high Tg mono-functional polymerizable component) as the first polymerized layer 600. Multi-layer stacks were also prepared with polymerizable composition 2 (low Tg mono-functional component) as the first polymerized layer.

| **Component** | **Composition 1 (wt%)** | **Composition 2 (wt%)** |
|---|---|---|
| IBOA | 56 | |
| MEDOL 10 | 19 | 48 |
| HDODA | 20 | |
| SR247 | | 48 |
| IRGACURE 907 | 1 | 1.5 |
| DAROCUR 4265 | 4 | |
| TPO | | 2.5 |

The silicon-containing layer 608 was etched back with fluorine and a carrier gas, oxidation was performed to conserve the hard mask, and a transfer layer etch was performed with oxygen and a carrier gas to form recesses in the etched multi-layer stack. The process parameters shown in Table 2 below were used for etching multi-layer stacks formed with compositions 1 and 2.

| **Parameter** | **Etchback** | **Oxidation** | **TL Etch** |
|---|---|---|---|
| Power | 50 W | 50 W | 90 W |
| Pressure | 10 mTorr | 30 mTorr | 6 mTorr |
| Gas 1 | 20 sccm O₂ | 20 sccm O₂ | 3 sccm O₂ |
| Gas 2 | 20 sccm CHF₃ | | |
| Gas 3 | 30 sccm Ar | | |
| Time | 45 sec | 60 sec | 150 sec |

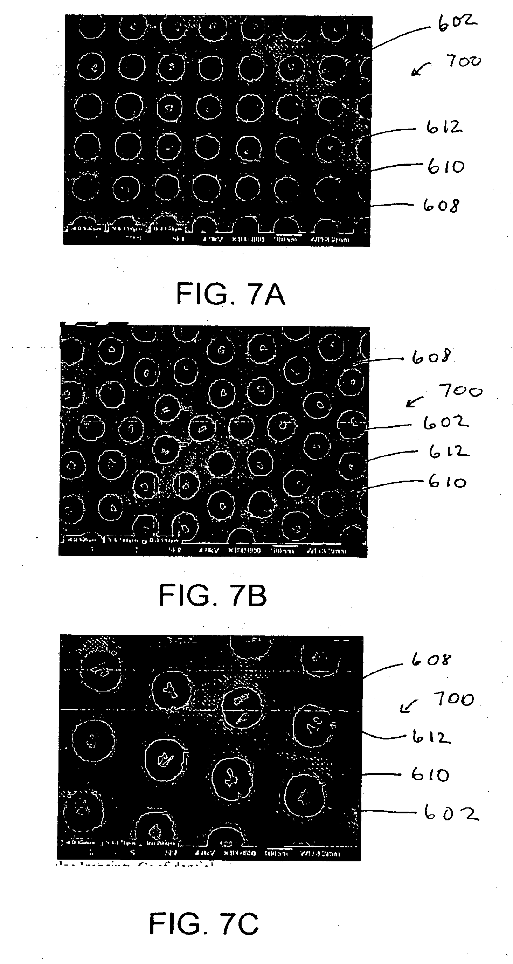

FIGS. 7A-C are scanning electron microscope (SEM) images (x 100,000) of an etched multi-layer stack 700 (top view) formed as described, with composition 1 as the first polymerized (non-silicon-containing) layer 606. Recesses 610 are spaced apart, with second polymerized (silicon-containing) layer 608 visible between the recesses. Residue 612 is readily apparent on substrate 602 at the bottom of recesses 610.

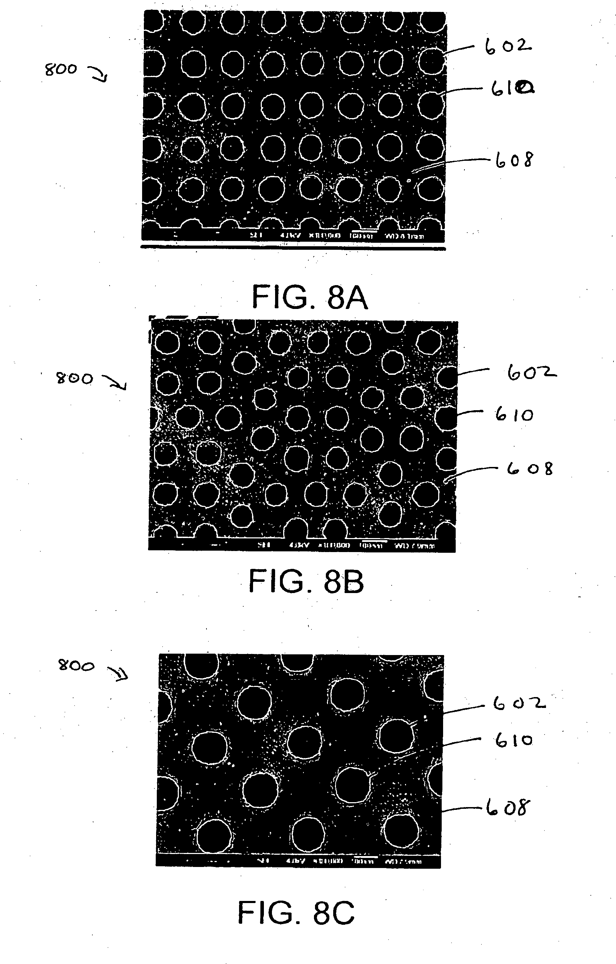

FIGS. 8A-C are SEM images (x 100,000) of an etched multi-layer stack 800 (top view) formed as described, with composition 2 as the first polymerized (non-silicon-containing) layer 606. Recesses 610 are spaced apart, with second polymerized (silicon-containing) layer 608 visible between the recesses. Residue is substantially absent from recesses 610.

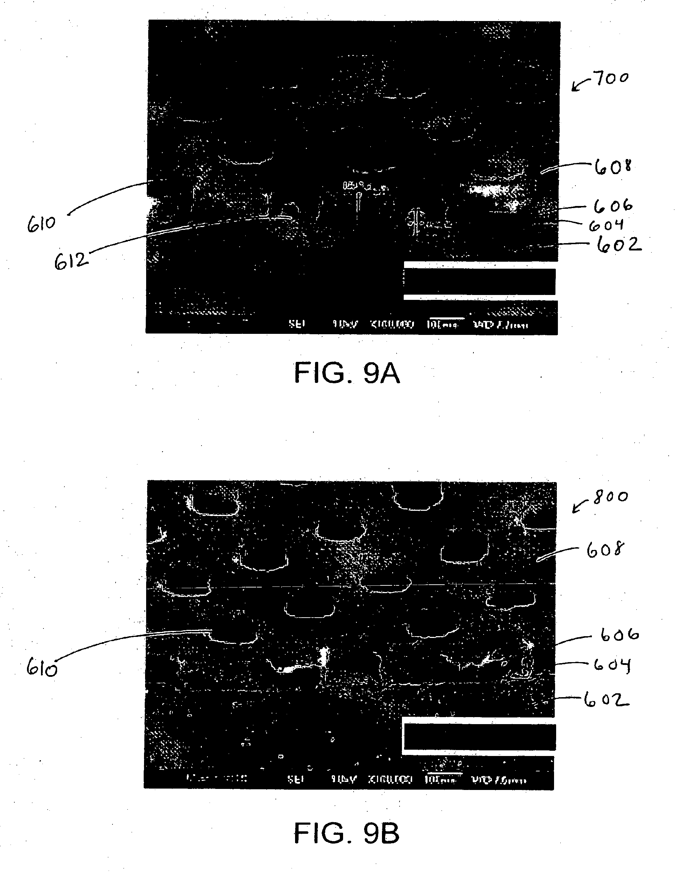

FIG. 9A is an SEM image (x 100,000) of a cross section of an etched multi-layer stack 700 formed with composition 1 as the first polymerizable composition, with residue 612 visible (cylindrically shaped, diameter of about 40 nm) in recesses 610. FIG. 9B is an SEM image (x 100,000) of a cross section of an etched multi-layer stack 800 formed with composition 2 as the first polymerizable composition. FIG. 9B shows recesses 610 substantially free from residue, indicating that the polymerized layer formed from polymerizable composition 2 was substantially impermeable the second (silicon-containing) polymerizable composition.

A number of embodiments of the invention have been described. Nevertheless, it will be understood that various modifications may be made without departing from the spirit and scope of the invention. Accordingly, the invention is defined by the following claims.

## Claims

1. A method of forming a multi-layer stack in an imprint lithography process, the method comprising:
(i) applying a first polymerizable composition to a substrate;
(ii) polymerizing the first polymerizable composition to form a first polymerized layer;
(iii) applying a second polymerizable composition to the first polymerized layer; and
(iv) polymerizing the second polymerizable composition to form a second polymerized layer on the first polymerized layer, wherein
the first polymerizable composition comprises a mono-functional polymerizable component, whose homopolymer has a glass transition temperature less than about 25° C, a multi-functional polymerizable component and a photoinitiator, wherein
the relative reactivity of the mono-functional component and the multi-functional component allows a substantially complete polymerization of the first polymerizable composition, and
the first polymerized layer is substantially impermeable to the second polymerizable composition.

2. The method of claim 1 wherein the first polymerizable composition comprises less than about 1 wt % silicon.

3. The method of claim 2, wherein the first polymerizable composition comprises less than about 0.1 wt % silicon.

4. The method of claim 2 or 3, wherein the first polymerizable composition is substantially free from silicon.

5. The method of claim 1 or 2 wherein the second polymerizable composition is silicon-containing.

6. The method of claim 5, wherein the second polymerizable composition comprises at least about 5 wt % silicon.

7. The method of claim 6, wherein the second polymerizable composition comprises at least about 10 wt % silicon.

8. The method of claim 1 or 5, wherein the homopolymer of the mono-functional polymerizable component has a glass transition temperature less than about 15° C.

9. The method of claim 8, wherein the homopolymer of the mono-functional polymerizable component has a glass transition temperature less than about 0° C.

10. The method of claim 1, wherein the mono-functional polymerizable component comprises (2-ethyl-2-methyl-1,3-dioxolan-4-yl)methyl acrylate.

11. The method of claim 1, wherein the multi-functional polymerizable component comprises neopentyl glycol diacrylate.

12. An imprint lithography process using a multi-layer stack formed by a method according to any one of the preceding claims, further comprising the steps of etchback and transfer etching of the multi-layer stack.

## Patentansprüche

1. Verfahren zur Bildung eines Mehrschichtstapels in einem Imprintlithographieprozess, das Verfahren umfassend:
(i) Aufbringen einer ersten polymerisierbaren Zusammensetzung auf ein Substrat;
(ii) Polymerisieren der ersten polymerisierbaren Zusammensetzung, um eine erste polymerisierte Schicht zu bilden;
(iii) Aufbringen einer zweiten polymerisierbaren Zusammensetzung auf die erste polymerisierte Schicht; und
(iv) Polymerisieren der zweiten polymerisierbaren Zusammensetzung, um eine zweite polymerisierte Schicht auf der ersten polymerisierten Schicht zu bilden, wobei
die erste polymerisierbare Zusammensetzung eine monofunktionale polymerisierbare Komponente umfasst, deren homopolymer eine Glasübergangstemperatur von weniger als ungefähr 25°C, eine multifunktionale polymerisierbare Komponente und einen Fotoinitiator aufweist, wobei die relative Reaktivität der monofunktionalen Komponente und der multifunktionalen Komponente eine im Wesentlichen vollständige Polymerisierung der ersten polymerisierbaren Zusammensetzung erlaubt, und die erste polymerisierte Schicht für die zweite polymerisierbare Zusammensetzung im Wesentlichen undurchlässig ist.

2. Verfahren nach Anspruch 1, wobei die erste polymerisierbare Zusammensetzung weniger als ungefähr 1 Gew.-% Silizium umfasst.

3. Verfahren nach Anspruch 2, wobei die erste polymerisierbare Zusammensetzung weniger als ungefähr 0.1 Gew.-% Silizium umfasst.

4. Verfahren nach Anspruch 2 oder 3, wobei die erste polymerisierbare Zusammensetzung im Wesentlichen frei von Silizium ist.

5. Verfahren nach Anspruch 1 oder 2, wobei die zweite polymerisierbare Zusammensetzung siliziumenthaltend ist.

6. Verfahren nach Anspruch 5, wobei die zweite polymerisierbare Zusammensetzung mindestens ungefähr 5 Gew.-% Silizium umfasst.

7. Verfahren nach Anspruch 6, wobei die zweite polymerisierbare Zusammensetzung mindestens ungefähr 10 Gew.-% Silizium umfasst.

8. Verfahren nach Anspruch 1 oder 5, wobei das homopolymer der monofunktionalen polymerisierbaren Komponente eine Glasübergangstemperatur von weniger als ungefähr 15°C aufweist.

9. Verfahren nach Anspruch 8, wobei das Homopolymer der monofunktionalen polymerisierbaren Komponente eine Glasübergangstemperatur von weniger als ungefähr 0°C aufweist.

10. Verfahren nach Anspruch 1, wobei die monofunktionale polymerisierbare Komponente (2-Ethyl-2-Methyl-1,3-Dioxolan-4-yl)Methylakrylat umfasst.

11. Verfahren nach Anspruch 1, wobei die multifunktionale polymerisierbare Komponente Neopentyl Glykol Diakrylat umfasst.

12. Imprintlithografieprozess unter Verwendung eines Mehrschichtstapels gebildet durch ein Verfahren nach einem der vorhergehenden Ansprüche, weiter umfassend die Schritte der rückseitigen Ätzens und Transferätzens des Mehrschichtstapels.

## Revendications

1. Procédé de formation d'un empilement multicouche dans un processus de lithographie par impression, le procédé comprenant :
(i) l'application d'une première composition polymérisable sur un substrat ;
(ii) la polymérisation de la première composition polymérisable afin de former une première couche polymérisée ; et
(iii) l'application d'une seconde composition polymérisable sur la première couche polymérisée ; et
(iv) la polymérisation de la seconde composition polymérisable afin de former une seconde couche polymérisée sur la première couche polymérisée, dans lequel la première composition polymérisable comprend un composant polymérisable monofonctionnel, dont l'homopolymère a une température de transition vitreuse inférieure à environ 25 °C, un composant polymérisable multifonctionnel et un photo-initiateur, dans lequel
la réactivité relative du composant monofonctionnel et du composant multifonctionnel permet une polymérisation substantiellement complète de la première composition polymérisable, et
la première couche polymérisée est substantiellement imperméable à la seconde composition polymérisable.

2. Procédé selon la revendication 1, dans lequel la première composition polymérisable comprend moins qu'environ 1 % en poids de silicium.

3. Procédé selon la revendication 2, dans lequel la première composition polymérisable comprend moins qu'environ 0,1 % en poids de silicium.

4. Procédé selon la revendication 2 ou 3, dans lequel la première composition polymérisable est substantiellement exempte de silicium.

5. Procédé selon la revendication 1 ou 2, dans lequel la seconde composition polymérisable contient du silicium.

6. Procédé selon la revendication 5, dans lequel la seconde composition polymérisable comprend au moins environ 5 % en poids de silicium.

7. Procédé selon la revendication 6, dans lequel la seconde composition polymérisable comprend au moins environ 10 % en poids de silicium.

8. Procédé selon la revendication 1 ou 5, dans lequel l'homopolymère du composant polymérisable monofonctionnel possède une température de transition vitreuse inférieure à environ 15 °C.

9. Procédé selon la revendication 8, dans lequel l'homopolymère du composant polymérisable monofonctionnel possède une température de transition vitreuse inférieure à environ 0 °C.

10. Procédé selon la revendication 1, dans lequel le composant polymérisable mono fonctionnel comprend de l'acrylate de méthyle de 2-éthyl-2-méthyl-1,3-dioxolan-4-yle.

11. Procédé selon la revendication 1, dans lequel le composant polymérisable multifonctionnel comprend du diacrylate de néopentylglycol.

12. Processus de lithographie par impression utilisant un empilement multicouche formé par un procédé selon l'une quelconque des revendications précédentes, comprenant en outre les étapes d'une gravure en retrait et d'une gravure par transfert de l'empilement multicouche.
